(19) Europäisches Patentamt
European Patent Office
Office européen des brevets

(11) EP 0 632 461 B1

(12) **EUROPEAN PATENT SPECIFICATION**

(45) Date of publication and mention
of the grant of the patent:
**25.02.1998 Bulletin 1998/09**

(51) Int Cl.⁶: **G11C 5/02**, G11C 8/00

(21) Application number: **94113312.6**

(22) Date of filing: **03.10.1989**

(54) **Memory device**

Speicheranordnung

Dispositif de mémoire

(84) Designated Contracting States:
**DE FR GB IT NL**

(30) Priority: **28.10.1988 US 264404**

(43) Date of publication of application:
**04.01.1995 Bulletin 1995/01**

(62) Document number(s) of the earlier application(s) in
accordance with Art. 76 EPC:
**89118312.1 / 0 365 876**

(73) Proprietor: **TEXAS INSTRUMENTS
INCORPORATED
Dallas Texas 75265 (US)**

(72) Inventors:
• **Kersh, David V, III
Houston, Texas 77036 (US)**

• **Childers, Jimmie Don
Missouri City, Texas 77489 (US)**

(74) Representative:
**Schwepfinger, Karl-Heinz, Dipl.-Ing.
Prinz & Partner,
Manzingerweg 7
81241 München (DE)**

(56) References cited:
**DE-A- 3 447 722          FR-A- 2 551 904**

• **PATENT ABSTRACTS OF JAPAN vol. 112, no. 46
(P-665) 12 February 1988 & JP-A-62 192 086
(MATSUSHITA ELECTRONICS CORP.)**

## Description

### TECHNICAL FIELD OF THE INVENTION

The present invention relates in general to a memory device as defined in the precharacterizing part of claim 1.

In DE-A-3 447 722 a memory device of this type is disclosed which makes use of a distributed decoder.

### BACKGROUND OF THE INVENTION

Industrial users of dynamic random access memories (DRAMs) are demanding ever-quicker timing and ever-smaller power specifications. To meet these specifications, designers must design DRAMs to read from and write to the DRAM storage cells more and more quickly while at the same time using less power. This requires that improved methods be discovered to drive DRAM word lines to $V_{dd}$ during the precharge portion of the reading cycle and to boot them above $V_{dd}$ during the active restore portion of the cycle. These functions are a substantial part of an active cycle's length.

A selected row line is driven for reading, and is booted for the active restore function, using a drive/boot signal transmitted from a drive/boot signal generator conventionally located in a peripheral area of the chip. An increasing importance has been placed on the decoding path of this drive/boot signal from the drive/boot generator to the active word lines. If this decoding path is too resistive or capacitive, the driving and booting of the word lines will be too slow. In addition, if the drive/boot signal path is too capacitive, the device will use too much power.

To illustrate the disadvantages of present drive/boot signal decoding systems, two examples will be described. In a pair of conventional 64K and 256K DRAM designs, one drive/boot generator is provided. Its output is split into two separate global signal lines (that is, signal lines that extend over the entire array) using pass gates. Therefore, only one of the split lines is required to be active in any given cycle. Each of the split lines then connects to one-half of all of the word line drivers or decoders in the DRAM in order to drive and boot the appropriate word lines. The row decoders are selected by addressing signals. Thus, in any given cycle, the one master drive/boot signal will "see" the parasitic capacitance of one-half of all of the word line drivers on the entire chip connected to it, plus the parasitic capacitance of two extra decoding pass gates. In addition to the relatively large amount of capacitance that this creates, the drive/boot signal is required to travel through the resistance of one pass gate and one word line driver to get to each decoded word line.

According to another conventional design used in 256K and 1M CMOS DRAMs, four drive/boot generators are provided with four separate global drive/boot signal lines. Only one of these signal lines is active for any given cycle. Each drive/boot signal line is directly connected to one-fourth of all of the word line drivers on the chip. The four generators used according to this method require more space on the chip than one large signal generator. Further, each of the four drive/boot signal lines is heavily loaded with one-fourth of the entire chip's word line drivers parasitic capacitance. Each drive/boot signal must furthermore travel through the resistance of one word line driver to reach each word line.

The above conventional drive/boot signal decoding solutions require that the drive/boot signal "see" an undesirably large amount of parasitic capacitance, thus slowing down cycle times. The importance of minimizing this capacitance increases with increasing cycle speed, smaller voltage differences and larger array sizes such as are mandated for the 4M DPAM. A need has therefore arisen for a drive/boot signal decoding scheme that will result in improved parasitic capacitance characteristics.

It is the problem to be solved by the invention to provide a decoding system having an improved parasitic capacitance characteristic.

### SUMMARY OF THE INVENTION

In accordance with the invention, the above-mentioned problem is solved by a memory device provided with the features of the characterizing part of claim 1. It is based on the provision of local predecoders, i.e. predecoders located directly adjacent the decoder sections.

A principal advantage of the invention is the reduction of the number of row line decoders "seen" by the main drive/boot signal. In a 4M DRAM design according to the invention, the parasitic capacitance of only 4/128 of the entire chip's word line drivers, plus the capacitance of an extra 128 predecoding pass gates, is seen by the main drive/boot signal. Each of the extra 128 predecoding pass gates is however about four times larger than each word line driver in order to make the word lines' rise time approximately the same as the rise time if the earlier 256K and 1M CMOS method was used. It is therefore estimated that the parasitic capacitance on the drive/boot line according to the invention, in a given cycle, is approximately equivalent to only one-tenth of the entire chip's word line driver parasitic capacitance. This allows the word lines to be driven faster and at the same time to use less power in doing it.

### BRIEF DESCRIPTION OF THE DRAWINGS

Further aspects of the invention and their advantages will be discerned by the following detailed description in conjunction with the drawings in which:

FIGURE 1 is a partial schematic plan layout showing a four megabit DRAM design according to the invention;
FIGURE 2 is a simplified schematic electrical layout of a small portion of the DRAM illustrated in FIGURE 1;

FIGURE 3 is a detailed electrical schematic diagram of a single predecoder according to the invention; and

FIGURE 4 is a detailed electrical schematic diagram of a single decoder according to the invention.

## DETAILED DESCRIPTION OF THE INVENTION

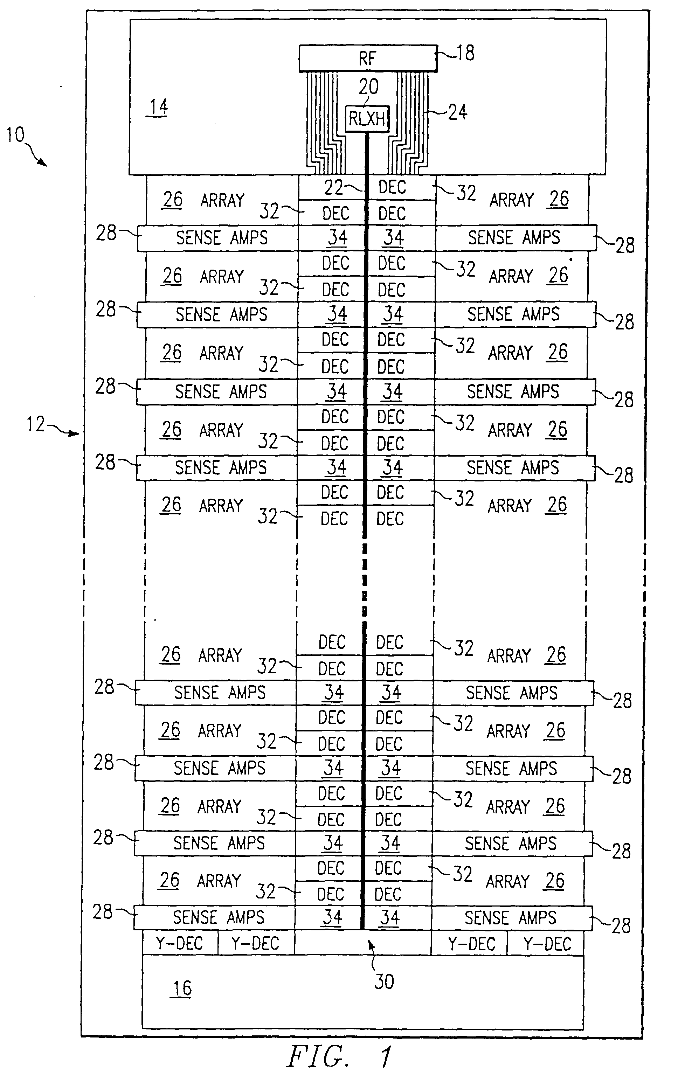

Referring first to FIGURE 1, a layout of a dynamic random access memory (DRAM) chip is shown generally at 10. The particular layout shown is for a four megabit DRAM. The chip 10 includes a cell array area indicated generally at 12, and a pair of end peripheral areas 14 and 16 adjacent the cell array area 12.

In the illustrated embodiment, a row factor signal generator 18 (RF) and a drive/boot signal generator 20 (RLXH) are formed in the peripheral area 14. The size and positioning of signal generators 18 and 20 are shown only schematically. The drive/boot signal generator 20 has an output that is connected to a drive/boot signal generator line 22 that runs down the middle of the array area 12. The row factor signal generator 18 has a plurality of row factor signal lines 24 (schematically illustrated; in one actual embodiment there are twenty such lines 24) that also run down the middle of the array area 12 so as to be substantially parallel to the drive/boot signal line 22.

The array area 12 contains a plurality of DRAM memory cell arrays 26 that are arranged in rows and columns. In the embodiment illustrated, there are thirty-two arrays 26 arranged in sixteen rows and two columns, each array having 128K memory cells. Only the first five and the last four of the rows are shown, the remaining seven middle rows being similar in construction and indicated by dashed continuation lines. The arrays 26 are spaced from each other in a vertical or columnar direction by respective ones of a plurality of sense amplifiers 28 and in a row or horizontal direction by a vertical space indicated generally at 30.

The vertical space 30 is in part occupied by a plurality of row decoder sections 32. The layout of the arrays 26, sense amplifiers 28 and row decoder sections 32 leaves a plurality of "holes" 34 that are used to lay out the predecoders and row redundancy decoders described below. The drive/boot signal line 22 and the row factor signal lines 24 are preferably routed down the length of the chip within the vertical space 30.

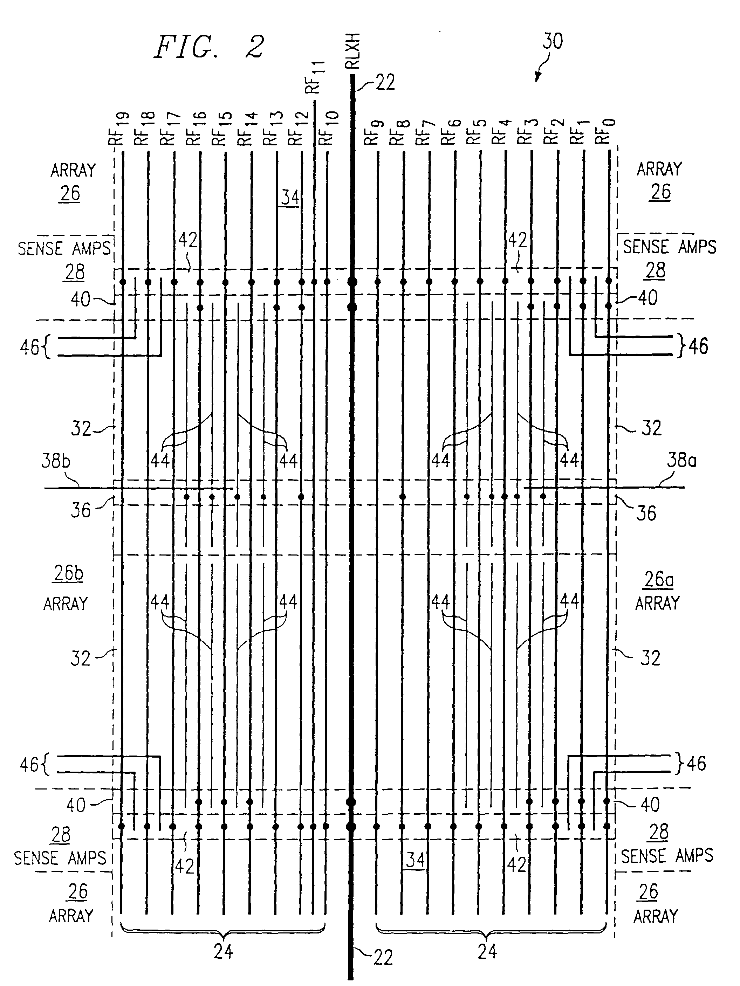

Turning now to FIGURE 2, a small detail of the layout shown in FIGURE 1 is illustrated. The areas devoted to laying out cell arrays 26, sense amplifiers 28, decoder sections 32, and the predecoders and row redundancy decoders described below are indicated by dashed lines. The row decoder sections 32 are preferably laid out in pairs back-to-back and extend across the vertical space 30 from one cell array 26a in the right column to the opposite cell array 26b in the left column. In the illustrated embodiment, there are thirty-two row decoders in each row decoder section 32, one such row decoder being indicated at 36, surrounded by a dashed enclosure. Each row decoder 36 is operable to decode the drive/boot signal line onto two of eight word lines, four of the word lines being disposed in the cell array 26a and the other four row lines being disposed in the cell array 26b. Two of these word lines are shown at 38a, 38b.

A predecoder 40 is preferably laid out to be adjacent a respective decoder section 32. Predecoders 40 are laid out to use at least some of the space provided by "holes" 34. Each decoder section 32 is further provided with a row redundancy decoder 42 that is preferably disposed in an area adjacent to a respective predecoder 40.

The drive/boot signal (RLXH) generator line 22 is constituted by a relatively wide conductor strap in second metal to minimize resistance and preferably runs down the middle of the vertical space 30. Line 22 is connected to each row redundancy decoder 42 and each predecoder 40 along the length of the chip, as shown schematically by the connection dots on line 22.

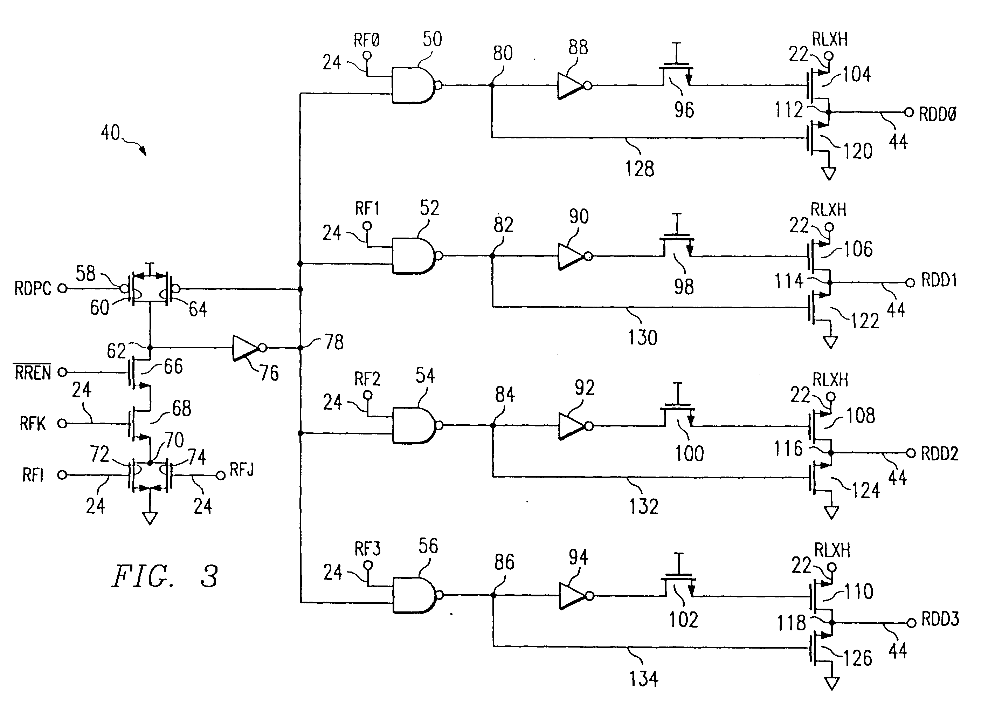

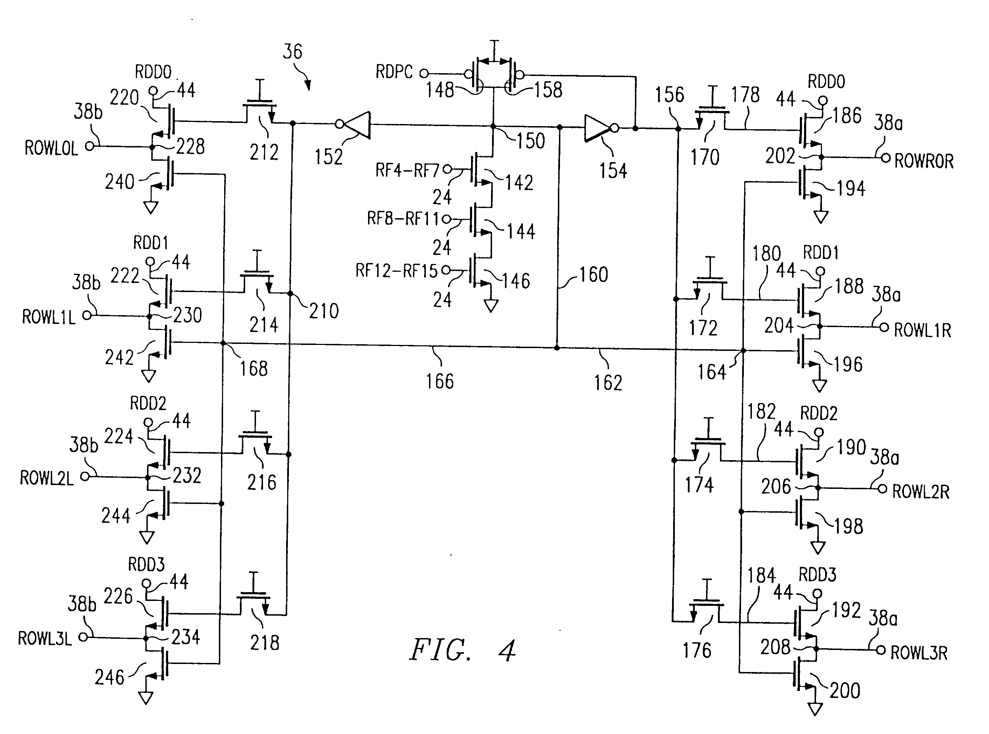

The row factor (RF) signal lines 24 are routed generally in parallel to the RLXH signal line 22. Each of the twenty row factor signal lines 24 are connected to each row redundancy decoder 42, but only selected ones of the row factor signal lines 24 are connected to any one of the predecoders 40 and the decoders 36. The row factor signal lines 24 are connected to a particular predecoder 40 or to a particular decoder 36 according to a decoding scheme described more particularly in conjunction with FIGURES 3 and 4.

A plurality of predecoder lines 44 originate within the predecoder 40 and are disposed generally in parallel with the row factor signal lines 24. The predecoder lines 44 are preferably formed in second metal where they are parallel to row factor lines 24, and in first metal when they run perpendicular thereto (not shown in this schematic representation). Each predecoder line 44 intersects and is connected with each decoder 36 in a respective decoder section 32. In the illustrated embodiment, there are four predecoder output lines 44 and the signal carried thereon are termed RDD0, RDD1, RDD2, and RDD3 (see FIGURE 3).

In the illustrated embodiment, each row redundancy decoder 42 is operable to decode the drive/boot signal onto a selected two of four redundant row lines 46. Four redundant row lines 46 are provided to replace up to two pairs of regular row lines 38 as needed. The row redundancy scheme herein mentioned is more particularly described in co-pending application Serial No. _____ (Attorney's Docket Number TI-12989).

Turning now to FIGURE 3, there is illustrated a detailed electrical schematic diagram of one of the predecoders 40. A plurality of selected row factor lines 24 are connected as inputs to the predecoder circuit 40, and their identity varies according to a predetermined decoding scheme. Row factor lines RF0 - RF3 are connected to respective inputs of four NAND gates 50-56. Row factor signal lines RF0 - RF3 are connected to each predecoder circuit 40 on the chip. On the other hand, the identity of three other row factor signal input lines RFI, RFJ and RFK vary according to the particular predecoder circuit 40 to which they are connected. The table below gives the identity of RFI, RFJ and RFK according to the cardinal number of the particular predecoder 40.

TABLE I

| Predecoder No. | RFI | RFJ | RFK |
|---|---|---|---|
| 0, 8, 16, 24 | RF12 | RF13 | RF16 |
| 1, 9, 17, 25 | RF14 | RF15 | RF16 |
| 2, 10, 18, 26 | RF12 | RF13 | RF17 |
| 3, 11, 19, 27 | RF14 | RF15 | RF17 |
| 4, 12, 20, 28 | RF12 | RF13 | RF18 |
| 5, 13, 21, 29 | RF14 | RF15 | RF18 |
| 6, 14, 22, 30 | RF12 | RF13 | RF19 |
| 7, 15, 23, 31 | RF14 | RF13 | RF19 |

Seven row factor signal lines thus make connection to the inputs of each predecoder 40, while the remaining thirteen do not.

A predecoder signal output precharge signal RDPC is connected to a gate 58 of a P-channel transistor 60. The current path of transistor 60 selectively connects a voltage supply source ($V_{dd}$) to a node 62. The current path of another P-channel transistor 64 is also operable to connect $V_{dd}$ to the node 62.

The drain of an N-channel transistor 66 is connected to the node 62, while a source thereof is connected to the drain of a further N-channel transistor 68. The source of the N-channel transistor 68 is connected to a node 70, which in turn is connected to the drains of two N-channel transistors 72 and 74. The sources of N-channel transistors 72 and 74 are connected to ground or $V_{ss}$. The row factor signal line RFK is connected to the gate of transistor 68. The gate of transistor 72 is connected to signal line RFI, while the gate of transistor 74 is connected to signal line RFJ. The gate of transistor 66 is connected to a row redundancy enable signal line $\overline{RREN}$.

Node 62 serves as the input to an inverter 76. The output of inverter 76 is connected to a node 78, which in turn is connected back to the gate of the P-channel transistor 64. Node 78 is also connected to second inputs of NAND gates 50-56.

The outputs of NAND gates 50-56 are connected to respective nodes 80, 82, 84 and 86. Each node 80-86 is connected to an input of a respective inverter 88-94. The output of each inverter 88-94 is connected to the source of a respective large pass gate transistor 96-102. Each of the pass gate transistors 96-102 has a gate thereof connected to $V_{dd}$.

The source of each pass gate transistor 96, 98, 100 and 102 is connected to the gate of a respective N-channel transistor 104, 106, 108 or 110. The sources of each of the transistors 104-110 are connected to the drive/boot signal line 22 (RLXH). The drains of transistors 104-110 are connected to respective nodes 112, 114, 116 and 118. Each node 112-118 is connected to the source of a respective grounding transistor 120, 122, 124 or 126. The drains of the grounding transistors 120-126 are connected to ground or $V_{ss}$. The gates of each transistor 120-126 are connected by respective lines 128-134 back to respective nodes 80-86. Each node 112-118 is connected to a respective predecoder output line RDD0-RDD3.

Turning next to FIGURE 4, a detailed schematic diagram of one decoder circuit 36 is illustrated. Decoder circuit 36 is enabled by high states of three row factor signals appearing on the respective gates of enabling transistors 142, 144 and 146 in the center of FIGURE 3. The RF line 24 connected to the gate of transistor 142 is selected from one of RF4 through RF7. Similarly, the RF signal line connected to the gate of transistor 144 is selected from RF8 through RF11, and the row factor signal line 24 that is connected to the gate of transistor 146 is selected from RF12 through RF15. The selection as to which of these lines is connected to the particular decoder circuit 36 varies according to the identity of the particular decoder circuit 36 within the decoder section 32 (FIGURE 2). In this way, one out of the thirty-two decoders within any decoder section 32 can be selected.

A row decoder precharge signal line RDPC is connected to the gate of a P-channel transistor 148. The current path of transistor 148 connects a voltage supply $V_{dd}$ to a node 150. Node 150 is connected to the inputs of left and right inverters 152 and 154. The output of inverter 154 is connected to a node 156, which is in turn connected back to the gate of a P-channel transistor 158. The current path of transistor 158 connects a $V_{dd}$ voltage supply to node 150. Node 150 is connected through lines 160 and 162 to a node 164, and is further connected through lines 160 and 166 to a node 168. Node 150 is selectively connected through the current paths of selecting transistors 142, 144 and 146 to $V_{ss}$ or ground.

Right inverter output node 156 is connected to the sources of each of four pass transistors 170, 172, 174 and 176. The drains of transistors 170-176 are in turn respectively connected to lines 178, 180, 182 and 184. Lines 178-184 are in turn connected to the gates of respective self-booting decoding transistors 186, 188, 190 and 192.

Node 164 is connected to the gate of each of four row line grounding transistors 194, 196, 198 and 200. Grounding transistors 194-200 are operable to connect respective word line nodes 202, 204, 206 and 208 to ground. Each row line node 202-208 is connected to a respective right array row line ROWL0R, ROWL1R, ROWL2R, or ROWL3R.

The decoding circuitry for the left array is similar to that for the right array. An output node 210 of left inverter 152 is connected to the source of each of a plurality of pass gate transistors 212, 214, 216 and 218. The drain of each of the pass gate transistors 212-218 is connected to a gate of a respective self-booting decoding transistor 220, 222, 224 or 226. The current path of each decoding transistor 220-226 connects a respective predecoder output line RDD0-RDD3 to a respective left array row line node 228, 230, 232 or 234. The left array row lines ROWL0L, ROWL1L, ROWL2L and ROWL3L are connected to the respective left array row line nodes 28-234.

The decoding of a drive/boot signal onto selected ones of the left and right row lines is as follows. Referring again to FIGURE 1, a plurality of row factor signals are generated by the row factor signal generator 18 in the peripheral area 14. These travel by selected row factor lines 24 to each decoder and predecoder on the chip 10. High row factor signal states will be generated on one of lines RF0-RF3, one of lines RF4-RF7, one of lines RF8-RF11, one of lines RF12-RF15, and one of lines from RF16-19. Turning now to FIGURE 3 and as shown by Table I set out above, either RFI or RFJ of certain selected predecoder circuits 40 will be on so that either the gate of transistor 72 or the gate of transistor 74 will be turned on.

Turning back momentarily to FIGURE 1, the architecture of the DRAM illustrated is divided into four quadrants, and the decoding scheme is such that one predecoder will be selected for each quadrant out of the the eight predecoders in the quadrant. A DRAM according to the invention could also be divided into halves, octants, or any other portions containing an integral quotient of the total number of predecoders.

With reference to FIGURE 3, this means that for the selected predecoders, RFK and one RFI or RFJ will be in the high state, while the remaining seven of the eight predecoders in the quadrant will not have this enabling combination. The signal $\overline{RREN}$ must also be high to prevent the disabling of the entire predecoder. Finally, the precharge signal RDPC must go high to switch off P-channel transistor 58 so that node 62 can be pulled low. In each of the selected predecoders 40, the low state of node 62 will be inverted to a high state on node 78, which in turn will enable each of the NAND gates 50-56. Only one of the row factor signals RF0-RF3 will be high, while the rest will be low. Therefore, a selected one of the NAND gate output nodes 80-86 will be low, for example, node 82. The low state at node 82 will be inverted by inverter 90 to a high state at the drain of the transistor 98. Transistor 98 is operable to transfer this high state, minus a $V_t$ drop, to the gate of the respective decoding transistor 106.

Referring briefly back to FIGURE 1, a drive signal RLXH will be sent down the drive/boot signal line 22 from the peripheral area 14 into the cell array area 12.

Referring back to FIGURE 3, the (in this example) turned-on decoding transistor 106 will self-boot its gate to above $V_{dd}+V_t$, as both node RLXH and node 114 rise, thus allowing a full $V_{dd}$ to appear at node 114, which in turn is output on the RDD1 predecoder output line.

Referring now to FIGURE 4, RDD1 appears at the drains of both the left decoding transistor 222 and right decoding transistor 188. The RF signals sent down the length of the chip from the RF signal generator 18 (FIGURE 1) will have selected one out of thirty-two decoders 36 in each decoding section 32 on the chip. The combination of selecting one out of eight predecoders 40 in each quadrant, one RDD line out of four RDD lines per predecoder 40, and one decoder 36 out of thirty-two decoders 36 (FIGURE 2) per predecoder 40, means that only two row lines will be active per quadrant. In addition, the parasitic capacitance of only sixty-four decoding transistors of the thirty-two decoders 36 per quadrant is seen by the RLXH drive/boot signal, as the parasitic capacitance of the remaining one hundred and ninety-two decoding transistors of the thirty-two decoders 36 is masked by the nonselected parts of the selected predecoders 40, in other words, the three nonactive RDD lines. All of the parasitic capacitance of the other decoding transistors in the quadrant are masked from the RLXH drive/boot signal by the nonselected predecoders 40 in the quadrant.

A low state at the decoder selecting node 150 in a selected decoder 36 (FIGURE 4) will be inverted by the inverters 152 and 154 and will therefore appear as high states at nodes 156 and 210. The high states at nodes 156 and 210 are passed through the transistors 170, 172, 174, 176, 212, 214, 216, and 218 to actuate the gates of right decoding transistors 186-192 and left decoding transistors 220-226. However, this results in a $V_t$ drop across transistors 170-176 and 212-218 as the gates of transistors 186-192 and 220-226 are charged to $V_{dd}-V_t$. The high state at the inverter output node 156 will also turn off the precharging transistor 158. The precharging transistor 148 will be turned off by a high state of RDPC.

In the case of the nonselected decoders 36, the state at node 150 will be high. This high state is communicated through lines 160, 162 and 166 to the gates of each of the right and left row line discharge transistors 194, 196, 198, 200, 240, 242, 244 and 246. Therefore, the right row line nodes 202-208 and the left row lines nodes 228-234 will stay discharged.

Assuming that node 150 is high, however, each of the current paths of transistors 186-192 and 220-226 will be actuated to transmit a high state appearing on any of the predecoder output lines RDD0 - RDD3 to an appropriate set of right and left row lines. Carrying through the example that RDD1 is high and RDD0, RDD2, and RDD3 are low, the high RDD1 signal would be transmitted through the current path of transistors 188 and 222 to respective left and right row line nodes 230 and 204, which self-boot the gate of transistors 188 and 222 to at

least $V_{dd}+V_t$, disallowing any $V_t$ drop across transistors 188 and 222. Transmission lines ROWL1R and ROWL1L would thereby be driven by the drive signal RLXH. This same current path established by the decoding of the predecoder circuit 40 (FIGURE 3) and the decoder circuit 36 (FIGURE 4) is used for the booting signal subsequently transmitted by the drive/boot generator to ROWL1R and ROWL1L during an active restore portion of the DRAM cycle.

In summary, a two-tier decoding scheme has been disclosed that prevents the drive/boot signal from "seeing" the parasitic capacitance of all but a small number of decoder circuits. Since the predecoder circuits are disposed locally on the chip, a global drive/boot signal line can be used without excessive power dissipation.

While a preferred embodiment and its advantages have been described in the above detailed description, the invention is not limited thereto but only by the scope of the appended claims.

## Claims

1. A memory device comprising:

a plurality of arrays (26) of memory cells within the array area (12) of said memory device, said arrays (26) formed in a plurality of parallel rows and columns;

a plurality of decoder sections (32) each containing a plurality of decoders (36), each array (26) spaced from a next adjacent array (26) in a row direction by at least one of said decoder sections (32);

a plurality of predecoders (40) formed in said array area (12) and connected to said decoder sections,

characterised in that there are four of said decoder sections (32) arranged in a 2 x 2 matrix between each pair of arrays in said row direction, and in that: each matrix of said decoder sections (32) is spaced from a next adjacent matrix of said decoder sections (32) in a column direction by at least one of said predecoders (40).

## Patentansprüche

1. Speichervorrichtung, mit:

mehreren Matrizen (26) aus Speicherzellen innerhalb des Matrixbereichs (12) der Speichervorrichtung, wobei die Matrizen (26) aus mehreren parallelen Zeilen und Spalten gebildet sind;

mehreren Decodiererabschnitten (32), wovon jeder mehrere Decodierer (36) enthält, wobei jede Matrix (26) von einer nächsten, angrenzenden Matrix (26) in Zeilenrichtung durch wenigstens einen der Decodiererabschnitte (32) getrennt ist;

mehreren Vordecodierern (40), die in dem Matrixbereich (12) ausgebildet sind und an die Decodiererabschnitte angeschlossen sind,

dadurch gekennzeichnet, daß zwischen jedem Paar von Matrizen in der Zeilenrichtung vier der Decodiererabschnitte (32) in einer 2 × 2-Matrix angeordnet sind und daß jede Matrix aus Decodiererabschnitten (32) von der nächsten, angrenzenden Matrix aus Decodiererabschnitten (32) in einer Spaltenrichtung durch wenigstens einen der Vordecodiererabschnitte (40) getrennt ist.

## Revendications

1. Dispositif de mémoire comprenant :

une pluralité de réseaux (26) de cellules de mémoire à l'intérieur de la zone (12) de réseaux dudit dispositif de mémoire, lesdits réseaux (26) étant formés suivant une pluralité de lignes et de colonnes parallèles ; une pluralité de sections (32) de décodeurs contenant chacune une pluralité de décodeurs (36), chaque réseau (26) étant espacé d'un réseau adjacent suivant (26) dans une direction de ligne par au moins l'une desdites sections (32) de décodeurs ; une pluralité de prédécodeurs (40) formés dans ladite zone (12) de réseaux et connectés auxdites sections de décodeurs

caractérisé en ce qu'il y a quatre desdites sections (32) de décodeurs disposées dans une matrice de 2 x 2 entre chaque paire de réseaux dans ladite direction de ligne et en ce que chaque matrice desdites sections (32) de décodeurs est espacée d'une matrice adjacente suivante desdites sections (32) de décodeurs dans une direction de colonne par au moins l'un desdits prédécodeurs (40).

FIG. 1

FIG. 2

FIG. 3

FIG. 4